# EUROPEAN PATENT APPLICATION

(11) **EP 4 293 368 A1**
(43) Date of publication of application: **20.12.2023**
(21) Application number: 21947974.8
(22) Date of filing: 26.10.2021
(51) Int. Cl.: G01R 31/00

(54) **POWER SUPPLY SYSTEM IDENTIFICATION METHOD AND SYSTEM, AND RELATED ASSEMBLY**

(30) Priority: 29.06.2021 CN 202110731952
(71) Applicant: CRRC Zhuzhou Electric Locomotive Research Institute Co., Ltd., Zhuzhou, Hunan 412001 (CN)
(72) Inventor: CHEN, Xin, Zhuzhou, Hunan 412001 (CN); WEN, Yuliang, Zhuzhou, Hunan 412001 (CN); FU, Gang, Zhuzhou, Hunan 412001 (CN); HU, Jingyu, Zhuzhou, Hunan 412001 (CN); PENG, Yun, Zhuzhou, Hunan 412001 (CN); WANG, Yue, Zhuzhou, Hunan 412001 (CN); WU, Yi, Zhuzhou, Hunan 412001 (CN); ZHOU, Zhenbang, Zhuzhou, Hunan 412001 (CN); ZHANG, Yan, Zhuzhou, Hunan 412001 (CN)
(74) Representative: Behr, Wolfgang
(86) International application number: PCT/CN2021/126233
(87) International publication number: WO 2023/273047

(57) **Abstract**

A power supply system identification method and system, an electronic device, a multi-current system rail vehicle, and a computer-readable storage medium. The power supply system identification method comprises: acquiring a network voltage signal according to an acquisition period (S101); identifying a network voltage mode according to instantaneous values of network voltage signals of a plurality of acquisition periods within a preset time period, the network voltage mode being an alternating current mode or a direct current mode (S 102); if the network voltage mode is a direct current mode, determining the current direct current power supply system according to the instantaneous values of the network voltage signals within the preset time period (S103); and if the network voltage mode is an alternating current mode, determining the current alternating current power supply system according to the instantaneous values and frequencies of the network voltage signals within the preset time period (104). The method identifies a power supply system by means of an existing network voltage detection device of a multi-current system rail transit vehicle, without adding an external device, thereby reducing cost and improving the accuracy of identification.

## Description

The present application claims priority to Chinese Patent Application No. 202110731952.0, titled "METHOD AND SYSTEM FOR IDENTIFYING POWER SUPPLY SYSTEM, AND RELATED COMPONENTS", filed on June 29, 2021 with the China National Intellectual Property Administration, which is incorporated herein by reference in its entirety.

### FIELD

The present disclosure relates to the field of rail transit, and in particular to a method and a system for identifying a power supply system, and related components.

### BACKGROUND

In order to meet international market requirements for multiple traction power supply systems across different countries or different regions, research on multi-system rail vehicles is strengthened in China in recent years. The multi-system rail vehicles include multiple hardware systems respectively matching different traction power supply systems. Under different traction power supply systems, the multi-system rail vehicles switch between different hardware systems to operate. It is required for the multi-system rail vehicles to accurately identify different traction power supply systems. Once the traction power supply system is inaccurately identified, the traction power supply system does not match the hardware system, resulting in a risk of burning out components on a main circuit in the hardware system.

In the conventional technology, a detection device is usually arranged outside a vehicle to detect and identify a power supply system, increasing the cost. In addition, with the conventional technology, it is required for the detection device to interact with control devices, such as a TCU (traction control unit) and a CCU (central control unit), in the multi-system rail vehicle to transmit a detection result to the TCU and/or the CCU, resulting in problems such as signal loss in the interaction process, and then reducing the operation stability of the multi-system rail vehicle.

Therefore, how to provide a solution to the above technical problems is a problem required to be solved currently by those skilled in the art.

### SUMMARY

A method and a system for identifying a power supply system, an electronic device, a multi-system rail vehicle and a computer-readable storage medium are provided according to the present disclosure, to identify a power supply system by using a grid-voltage detection device in the multi-system rail vehicle without an external device, thereby reducing the cost and improving the accuracy of identification.

In order to solve the above technical problems, a method for identifying a power supply system is provided according to the present disclosure. The method is applied to a grid-voltage detection device in a multi-system rail vehicle. The method includes: acquiring a grid voltage signal with an acquisition period; identifying a grid voltage mode based on instant values of grid voltage signals in multiple acquisition periods in a predetermined time period, where the grid voltage mode includes an alternating current mode and a direct current mode; determining, in a case that that the grid voltage mode is the direct current mode, a current direct-current power supply system based on the instant values of the grid voltage signals in the predetermined time period; and determining, in a case that the grid voltage mode is the alternating current mode, a current alternating-current power supply system based on the instant values and a frequency of the grid voltage signals in the predetermined time period.

In an embodiment, the identifying a grid voltage mode based on instant values of grid voltage signals in multiple acquisition periods in a predetermined time period includes: determining whether a time duration, in which the instant values of the grid voltage signals are greater than a first predetermined value, in the predetermined time period is greater than a first predetermined duration; and determining that the grid voltage mode is the direct current mode in a case that the time duration is greater than the first predetermined duration.

In an embodiment, the determining whether a time duration, in which the instant values of the grid voltage signals are greater than a first predetermined value, in the predetermined time period is greater than a first predetermined duration includes: increasing a first counter by 1 in a case that an instant value of a grid voltage signal in a current acquisition period is greater than the first predetermined value; increasing a second counter by 1 in a case that an instant value of a grid voltage signal in a current acquisition period is less than a second predetermined value; determining whether a current time period obtained based on the current acquisition period and an initial time instant is greater than the predetermined time period; in a case that the current time period is not greater than the predetermined time period, acquiring a grid voltage signal with the acquisition period; increasing a third counter by 1 if the first counter is greater than the second counter and decreasing the third counter by 1 if the first counter is not greater than the second counter in a case that the current time period is greater than the predetermined time period; and determining, in a case that the third counter is greater than a third predetermined value, that the time duration in which the instant values of the grid voltage signals are greater than the first predetermined value is greater than the first predetermined duration.

In an embodiment, the identifying a grid voltage mode based on instant values of grid voltage signals in multiple acquisition periods in a predetermined time period includes: determining maximum values and minimum values of the grid voltage signals in the multiple acquisition periods; determining whether both a time duration in which the maximum values of the grid voltage signals in the predetermined time period are greater than a fourth predetermined value and a time duration in which the minimum values of the grid voltage signals in the predetermined time period are less than a fifth predetermined value are greater than a second predetermined duration, where the fourth predetermined value is greater than the fifth predetermined value, and the fourth predetermined value and the fifth predetermined value are opposite numbers to each other; and determining that the grid voltage mode is the alternating current mode in a case that both the time duration in which the maximum values of the grid voltage signals in the predetermined time period are greater than the fourth predetermined value and the time duration in which the minimum values of the grid voltage signals in the predetermined time period are less than the fifth predetermined value are greater than the second predetermined duration.

In an embodiment, the determining whether both a time duration in which the maximum values of the grid voltage signals in the predetermined time period are greater than a fourth predetermined value and a time duration in which the minimum values of the grid voltage signals in the predetermined time period are less than a fifth predetermined value are greater than a second predetermined duration includes: determining whether a maximum value of a grid voltage signal in a current acquisition period is greater than the fourth predetermined value and whether a minimum value of the grid voltage signal in the current acquisition period is less than the fifth predetermined value; increasing a fourth counter by 1 in a case that the maximum value of the grid voltage signal in the current acquisition period is greater than the fourth predetermined value and the minimum value of the grid voltage signal in the current acquisition period is less than the fifth predetermined value; decreasing the fourth counter by 1 in a case that the maximum value of the grid voltage signal in the current acquisition period is not greater than the fourth predetermined value or the minimum value of the grid voltage signal in the current acquisition period is not less than the fifth predetermined value; determining whether a current time period obtained based on the current acquisition period and an initial time instant is greater than the predetermined time period; acquiring a grid voltage signal with the acquisition period in a case that the current time period is not greater than the predetermined time period; determining whether the fourth counter is greater than a sixth predetermined value in a case that the current time period is greater than the predetermined time period; and determining, in a case that the fourth counter is greater than the sixth predetermined value, that both the time duration in which the maximum values of the grid voltage signals in the predetermined time period are greater than the fourth predetermined value and the time duration in which the minimum values of the grid voltage signals in the predetermined time period are less than the fifth predetermined value are greater than the second predetermined duration.

In an embodiment, the method for identifying a power supply system further includes: controlling a fifth counter to start counting in a case that a grid voltage signal in a current acquisition period meets an initial zero-crossing condition; increasing the fifth counter by 1 each time a grid voltage signal is acquired, and controlling the fifth counter to stop counting when the grid voltage signal in the current acquisition period meets a target zero-crossing condition; and obtaining a frequency of the grid voltage signal based on the fifth counter. The initial zero-crossing condition is a condition in which an instant value of a grid voltage signal in a previous acquisition period is less than 0 and an instant value of the grid voltage signal in the current acquisition period is greater than 0, and the target zero-crossing condition is a condition in which the instant value of the grid voltage signal in the previous acquisition period is greater than 0 and the instant value of the grid voltage signal in the current acquisition period is less than 0.

To solve the above technical problems, a system for identifying a power supply system is further provided according to the present disclosure. The system is applied to a grid-voltage detection device in a multi-system rail vehicle. The system includes an acquisition module and an identification module. The acquisition module is configured to acquire a grid voltage signal with an acquisition period. The identification module is configured to: identify a grid voltage mode based on instant values of grid voltage signals in multiple acquisition periods in a predetermined time period, where the grid voltage mode includes an alternating current mode or a direct current mode; determine, in a case that that the grid voltage mode is the direct current mode, a current direct-current power supply system based on the instant values of the grid voltage signals in the predetermined time period; and determine, in a case that the grid voltage mode is the alternating current mode, a current alternating-current power supply system based on the instant values and a frequency of the grid voltage signals in the predetermined time period.

In an embodiment, the grid voltage mode is identified based on the instant values of the grid voltage signals in the multiple acquisition periods in the predetermined time period by: determining whether a time duration, in which the instant values of the grid voltage signals are greater than a first predetermined value, in the predetermined time period is greater than a first predetermined duration; and in a case that the time duration is greater than the first predetermined duration, determining that the grid voltage mode is the direct current mode.

In an embodiment, it is determined whether the time duration, in which the instant value of the grid voltage signals are greater than the first predetermined value, in the predetermined time period is greater than the first predetermined duration by: in a case that an instant value of a grid voltage signal in a current acquisition period is greater than the first predetermined value, increasing a first counter by 1; in a case that an instant value of a grid voltage signal in a current acquisition period is less than a second predetermined value, increasing a second counter by 1; determining whether a current time period obtained based on the current acquisition period and an initial time instant is greater than the predetermined time period; in a case that the current time period is not greater than the predetermined time period, acquiring a grid voltage signal with the acquisition period; in a case that the current time period is greater than the predetermined time period, increasing a third counter by 1 if the first counter is greater than the second counter, and decreasing the third counter by 1 if the first counter is not greater than the second counter; and in a case that the third counter is greater than a third predetermined value, determining that the time duration in which the instant values of the grid voltage signals are greater than the first predetermined value is greater than the first predetermined duration.

In an embodiment, the grid voltage mode is identified based on the instant values of the grid voltage signals in the multiple acquisition periods in the predetermined time period by: determining maximum values and minimum values of the grid voltage signals in the multiple acquisition periods; determining whether both a time duration in which the maximum values of the grid voltage signals in the predetermined time period are greater than a fourth predetermined value and a time duration in which the minimum values of the grid voltage signals in the predetermined time period are less than a fifth predetermined value are greater than a second predetermined duration, where the fourth predetermined value is greater than the fifth predetermined value, and the fourth predetermined value and the fifth predetermined value are opposite numbers to each other; and in a case that both the time duration in which the maximum values of the grid voltage signals in the predetermined time period are greater than the fourth predetermined value and the time duration in which the minimum values of the grid voltage signals in the predetermined time period are less than the fifth predetermined value are greater than the second predetermined duration, determining that the grid voltage mode is the alternating current mode.

In an embodiment, it is determined whether both the time duration in which the maximum values of the grid voltage signals in the predetermined time period are greater than the fourth predetermined value and the time duration in which the minimum values of the grid voltage signals in the predetermined time period are less than the fifth predetermined value are greater than the second predetermined duration by: determining whether a maximum value of a grid voltage signal in a current acquisition period is greater than the fourth predetermined value and whether a minimum value of the grid voltage signal in the current acquisition period is less than the fifth predetermined value; in a case that the maximum value of the grid voltage signal in the current acquisition period is greater than the fourth predetermined value and the minimum value of the grid voltage signal in the current acquisition period is less than the fifth predetermined value, increasing a fourth counter by 1; in a case that the maximum value of the grid voltage signal in the current acquisition period is not greater than the fourth predetermined value or the minimum value of the grid voltage signal in the current acquisition period is not less than the fifth predetermined value, decreasing the fourth counter by 1; determining whether a current time period obtained based on the current acquisition period and an initial time instant is greater than the predetermined time period; in a case that the current time period is not greater than the predetermined time period, acquiring a grid voltage signal with the acquisition period; in a case that the current time period is greater than the predetermined time period, determining whether the fourth counter is greater than a sixth predetermined value; and in a case that the fourth counter is greater than the sixth predetermined value, determining that both the time duration in which the maximum values of the grid voltage signals in the predetermined time period are greater than the fourth predetermined value and the time duration in which the minimum values of the grid voltage signals in the predetermined time period are less than the fifth predetermined value are greater than the second predetermined duration.

In an embodiment, the system for identifying a power supply system further includes a calculation module. The calculation module is configured to: control, in a case that a grid voltage signal in a current acquisition period meets an initial zero-crossing condition, a fifth counter to start counting; increase the fifth counter by 1 each time a grid voltage signal is acquired, and control the fifth counter to stop counting when the grid voltage signal in the current acquisition period meets a target zero-crossing condition; and obtain a frequency of the grid voltage signal based on the fifth counter. The initial zero-crossing condition is a condition in which an instant value of a grid voltage signal in a previous acquisition period is less than 0 and an instant value of the grid voltage signal in the current acquisition period is greater than 0, and the target zero-crossing condition is a condition in which the instant value of the grid voltage signal in the previous acquisition period is greater than 0 and the instant value of the grid voltage signal in the current acquisition period is less than 0.

In order to solve the above technical problems, an electronic device is further provided according to the present disclosure. The electronic device includes a memory and a processor. The memory stores a computer program. The processor is configured to execute the computer program to perform the method for identifying a power supply system described above.

In order to solve the above technical problems, a multi-system rail vehicle is further provided according to the present disclosure. The multi-system rail vehicle includes the electronic device described above.

In order to solve the above technical problems, a computer-readable storage medium is further provided according to the present disclosure. The computer-readable storage medium stores a computer program. The computer program, when executed by a processor, causes the processor to perform the method for identifying a power supply system described above.

A method for identifying a power supply system is provided according to the present disclosure. With the method, a power supply system is identified by using a grid-voltage detection device in a multi-system rail vehicle without an external device, reducing the cost, avoiding the problem of signal loss, thereby ensuring the operability of the multi-system rail vehicle. Moreover, considering small differences in effective values of grid voltage signals under some power supply systems, the power supply system is identified based on changes of instant values of grid voltage signals in a time period according to the present disclosure, thereby avoiding misidentification and thereby improving the accuracy of identification. A system for identifying a power supply system, an electronic device, a multi-system rail vehicle and a computer-readable storage medium are further provided according to the present disclosure, which have the beneficial effects described above.

### BRIEF DESCRIPTION OF THE DRAWINGS

In order to more clearly describe the embodiments of the present disclosure, drawings to be used in the description of the embodiments of the present disclosure are briefly described hereinafter. It is apparent that the drawings described below are merely used for describing the embodiments of the present disclosure, and those skilled in the art may obtain other drawings according to the drawings without any creative effort.
Figure 1a is a schematic structural diagram of a direct-current grid-voltage detection device according to the present disclosure;
Figure 1b is a schematic structural diagram of an alternating-current grid-voltage detection device according to the present disclosure;
Figure 2 is a flowchart of a method for identifying a power supply system according to the present disclosure;
Figure 3 is a flowchart of a method for identifying a direct-current grid voltage according to the present disclosure;
Figure 4 is a flowchart of a method for identifying an alternating-current grid voltage according to the present disclosure; and
Figure 5 is a schematic structural diagram of a system for identifying a power supply system according to the present disclosure.

### DETAILED DESCRIPTION OF EMBODIMENTS

A method and a system for identifying a power supply system, an electronic device, a multi-system rail vehicle and a computer-readable storage medium are provided according to the present disclosure, to identify a power supply system by using a grid-voltage detection device in a multi-system rail vehicle without an external device, thereby reducing the cost and improving the accuracy of identification.

In order to make the objectives, technical solutions and advantages of the embodiments of the present disclosure clearer, the technical solutions in the embodiments of the present disclosure will be described clearly and completely hereinafter with reference to the drawings in the embodiments of the present disclosure. Apparently, the described embodiments are a part of embodiments of the present disclosure, rather than all of embodiments. All other embodiments obtained by those skilled in the art based on the embodiments in the present disclosure without any creative efforts fall within the protection scope of the present disclosure.

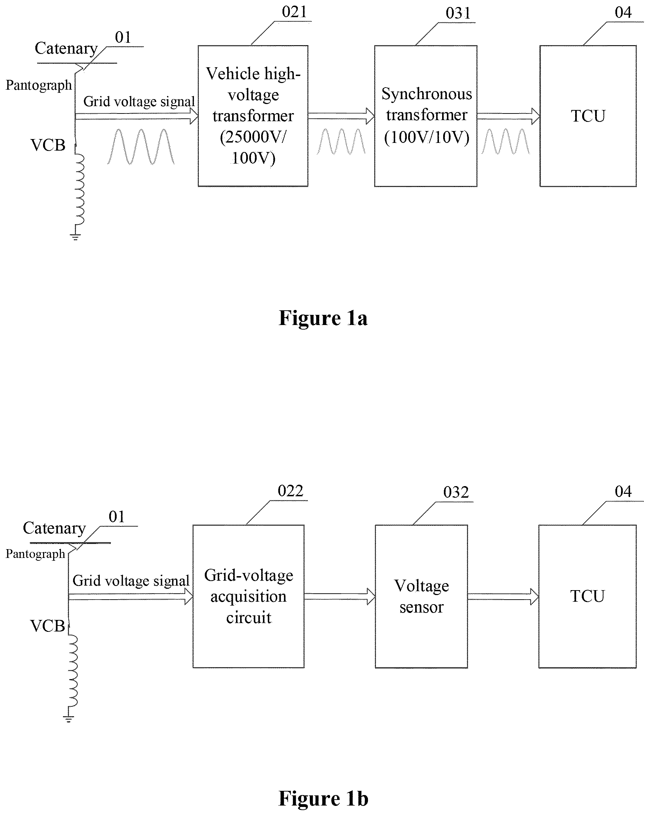

In order to facilitate understanding the method for identifying a power supply system according to the present disclosure, a grid-voltage detection device to which the method for identifying a power supply system according to the present disclosure is applicable is described firstly. Referring to Figure 1a, Figure 1a is a schematic structural diagram of an alternating-current grid-voltage detection device according to the present disclosure. The grid-voltage detection device includes a pantograph 01, a vehicle high-voltage transformer 021, a synchronous transformer 031 and a TCU 04. A grid voltage signal is acquired and transmitted as shown in Figure 1a. The vehicle high-voltage transformer 02 (25000V/100V) acquires a grid voltage through the pantograph 01, and then transmits the grid voltage to the synchronous transformer 03 (100V/10V) in a traction converter. The synchronous transformer 03 transmits an instant value of the grid voltage signal to the TCU 04. In the TCU 04, a multi-power supply system automatic identification is performed based on the acquired grid voltage signal. Referring to Figure 1b, Figure 1b is a schematic structural diagram of a direct-current grid-voltage detection device according to the present disclosure. The direct-current grid-voltage detection device includes a pantograph 01, a voltage acquisition circuit 022, a voltage sensor 032, and a TCU 04. A grid voltage signal is acquired and transmitted as shown in Figure 1b. The voltage acquisition circuit 022 acquires a grid voltage through the pantograph 01, and then transmits the grid voltage to the voltage sensor 032. The voltage sensor 032 transmits an instant value of the grid voltage signal to the TCU 04. In the TCU 04, a multi-power supply system automatic identification is performed based on the acquired grid voltage signal. It should be understood that in the embodiment, the alternating-current grid voltage signal and the direct-current grid voltage signal are acquired simultaneously, both the instant value of the alternating-current grid voltage signal and the instant value of the direct-current grid voltage signal are transmitted to the TCU 04, and the power supply system identification is performed based on the alternating-current grid voltage and the direct-current grid voltage.

The method for identifying a power supply system according to the present disclosure is described in detail below.

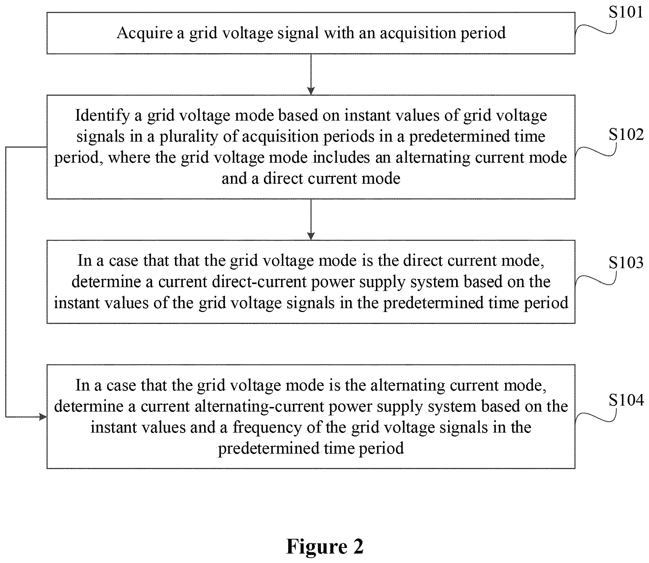

Referring to Figure 2, Figure 2 is a flowchart of a method for identifying a power supply system according to the present disclosure. The method for identifying a power supply system includes the following steps S101 to S104.

In step S101, a grid voltage signal is acquired with an acquisition period.

In step S 102, a grid voltage mode is identified based on instant values of grid voltage signals in multiple acquisition periods in a predetermined time period. The grid voltage mode includes an alternating current mode and a direct current mode.

It should be noted that the power supply system in the present disclosure includes a direct-current power supply system and an alternating-current power supply system. Grid voltage signals have different features under different power supply systems. For example, in a time period, both an amplitude and a direction of an alternating current signal periodically change over time, and a direction of a direct current signal does not periodically change over time. Therefore, in the above steps, a grid voltage signal is acquired with an acquisition period, then variation features of grid voltage signals are determined based on the grid voltage signals in multiple acquisition periods in a time period, and then it is determined whether the grid voltage signal is a direct current signal or an alternating current signal, thereby determining a grid voltage mode. In a case that the grid voltage signal is a direct current signal, the grid voltage mode is the direct current mode. In a case that the grid voltage signal is an alternating current signal, the grid voltage mode is the alternating current mode. The acquisition period is less than the predetermined time period. Assuming that the acquisition period is 1ms, the predetermined time period may be set to 10ms.

Specifically, considering that an effective value of a grid voltage is variable in some actual operation conditions, determination is not performed based on the effective value of the grid voltage in the embodiment, so that the determination is not affected by the effective value of the grid voltage. In addition, in some conditions, differences between effective values of grid voltages under some power supply systems are small, which may results in an inaccurate identification. In the embodiment, the grid voltage mode is identified based on the instant values of the grid voltage signals, thereby avoiding the inaccurate identification and improving the accuracy of identification.

In step S103, in a case that the grid voltage mode is the direct current mode, a current direct-current power supply system is determined based on the instant values of the grid voltage signals in the predetermined time period.

In a case that changes of the grid voltage signals in a time period conform to a change rule of a direct current signal, it may be determined that the grid voltage mode is the direct current mode. In this case, a current direct-current power supply system is determined based on the instant values of the grid voltage signals in the predetermined time period. Specifically, the current direct-current power supply system may be determined based on an instant value of a grid voltage signal acquired in an acquisition period closest to a current time instant in the predetermined time period. Alternatively, the current direct-current power supply system may be determined based on an average value of the instant values of the grid voltage signals acquired in the multiple acquisition periods in the predetermined time period. In a case that an instant value or an average value is a voltage value corresponding to DC3000V, it is determined that the current direct-current power supply system is DC3000V In a case that an instant value or an average value is a voltage value corresponding to DC 1500V, it is determined that the current direct-current power supply system is DC1500V

In step S104, in a case that the grid voltage mode is the alternating current mode, a current alternating-current power supply system is determined based on the instant values and a frequency of the grid voltage signals in the predetermined time period.

In a case that changes of the grid voltage signals in a time period conforms to a change rule of an alternating current signal, it is determined that the grid voltage mode is the alternating current mode. Generally, a frequency of an alternating-current grid voltage includes 50Hz, 60Hz and 16.7Hz. Therefore, it is required to determine the frequency of the grid voltage signal and then determine a, alternating-current power supply system based on the frequency and the instant values. Specifically, a voltage of the current alternating-current power supply system may be determined based on an instant value of a grid voltage signal acquired in an acquisition period closest to a current time instant in the predetermined time period. Alternatively, the voltage of the current alternating-current power supply system may be determined based on an average value of the instantaneous values of the grid voltage signals acquired in the multiple acquisition periods in the predetermined time period. In a case that an instant value or an average value is a voltage value corresponding to 25kV and a frequency is 50Hz, it is determined that the current alternating-current power supply system is 25kv/50Hz. In a case that an instant value or an average value is a voltage value corresponding to 25kV and a frequency is 60Hz, it is determined that the current alternating-current power supply system is 25kv/60Hz. In a case that an instant value or an average value is a voltage value corresponding to 15kV and a frequency is 16.7Hz, it is determined that the current alternating-current power supply system is 15kv/16.7Hz.

It can be seen that in the embodiments, a power supply system is identified by using a grid-voltage detection device in a multi-system rail vehicle without an external device, reducing the cost, avoiding the problem of signal loss, thereby ensuring the operability of the multi-system rail vehicle. Moreover, considering small differences in effective values of grid voltage signals under some power supply systems, the power supply system is identified based on changes of instant values of grid voltage signals in a time period according to the present disclosure, thereby avoiding misidentification and thereby improving the accuracy of identification.

Based on the above embodiments, in an embodiment, the grid voltage mode is identified based on the instant values of the grid voltage signals in the multiple acquisition periods in the predetermined time period by: determining whether a time duration, in which the instant values of the grid voltage signals are greater than a first predetermined value, in the predetermined time period is greater than a first predetermined duration; and in a case that the time duration is greater than the first predetermined duration, determining that the grid voltage mode is the direct current mode.

Specifically, as described above, the direction of the direct current signal does not periodically change over time. Therefore, in determining a direct-current grid voltage, two thresholds may be predetermined, that is, a first predetermined value A and a second predetermined value A1, where A>A1>0. In a case that the instant values of the grid voltage signals are constantly greater than the first predetermined value A in the predetermined time period, it is determined that the grid voltage signal is a direct current signal, and accordingly the grid voltage mode is the direct current mode.

In an embodiment, it is determined whether the time duration, in which the instant values of the grid voltage signals are greater than a first predetermined value, in the predetermined time period is greater than the first predetermined duration by: in a case that an instant value of a grid voltage signal in a current acquisition period is greater than the first predetermined value, increasing a first counter by 1; determining whether a current time period obtained based on the current acquisition period and an initial time instant is greater than the predetermined time period; in a case that the current time period is not greater than the predetermined time period, acquiring a grid voltage signal with the acquisition period; in a case that the current time period is greater than the predetermined time period, increasing a third counter by 1 if the first counter is greater than the second counter, and decreasing the third counter by 1 if the first counter is not greater than the second counter; and in a case that the third counter is greater than a third predetermined value, determining that the time duration in which the instant values of the grid voltage signals are greater than the first predetermined value is greater than the first predetermined duration.

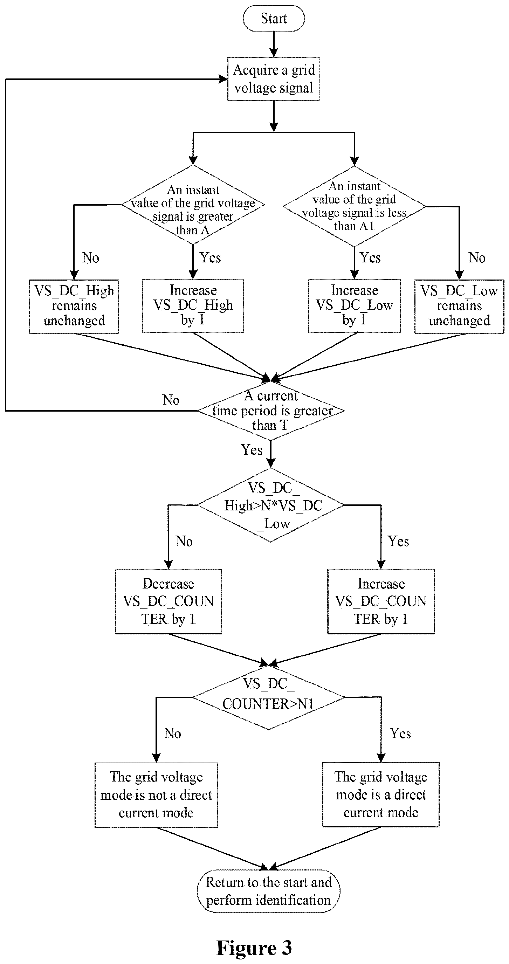

Specifically, as shown in Figure 3, an instant value of a grid voltage signal acquired by the TCU in a predetermined time period T is compared with the first predetermined value A and the second predetermined value A1. In a case that the instant value of the grid voltage signal is greater than the first predetermined value A, a first counter VS_DC_High is increased by 1. In a case that the instant value of the grid voltage signal is less than the second predetermined value A1, a second counter VS_DC_Low is increased by 1. In each of predetermined time periods, in a case that the first counter VS_DC_High is greater than N times the second counter VS_DC_Low, it is determined that the grid voltage signal in the predetermined time period is a direct current signal, and a third counter VS_DC_COUNTER is increased by 1; and in a case that the first counter VS_DC_High is not greater than N times the second counter VS_DC_Low, it is determined that the grid voltage signal in the predetermined time period is not a direct current signal and the third counter VS_DC_COUNTER is decreased by 1. In a case that the third counter is greater than a value N1 (where it requires (N1*T)ms for the third counter to be increased from 0 to N1), it is determined that the grid voltage signal is a direct current signal and a grid-voltage direct-current flag is set to 1.

Specifically, in addition to the above operations, the following operations may be performed. In each of predetermined time periods T, in a case that the first counter VS_DC_High is greater than N times the second counter VS_DC_Low, it is determined that the grid voltage signal in the predetermined time period is a direct current signal, and the third counter VS_DC_COUNTER is increased by 1; and in a case that the first counter VS_DC_High is not greater than N times the second counter VS_DC_Low, the third counter remains unchanged. In a case that the third counter is greater than a predetermined value in a predetermined time period T1 where T1>T, it is determined that the grid voltage signal is a direct current signal and the grid-voltage direct-current flag is set to 1.

In an embodiment, the grid voltage mode is identified based on instant values of grid voltage signals in multiple acquisition periods in a predetermined time period by: determining maximum values and minimum values of the grid voltage signals in the multiple acquisition periods; determining whether both a time duration in which the maximum values of the grid voltage signals in the predetermined time period are greater than a fourth predetermined value and a time duration in which the minimum values of the grid voltage signals in the predetermined time period are less than a fifth predetermined value are greater than a second predetermined duration, where the fourth predetermined value is greater than the fifth predetermined value, and the fourth predetermined value and the fifth predetermined value are opposite numbers to each other; and in a case that both the time duration in which the maximum values of the grid voltage signals in the predetermined time period are greater than the fourth predetermined value and the time duration in which the minimum values of the grid voltage signals in the predetermined time period are less than the fifth predetermined value are greater than the second predetermined duration, determining that the grid voltage mode is the alternating current mode.

Specifically, as described above, an amplitude and a direction of an alternating current signal periodically change over time in a time period. Therefore, in determining a alternating-current grid voltage, two thresholds may be predetermined, that is, a fourth predetermined value B and a fifth predetermined value -B, where B>0>-B. In a case that in the predetermined time period, the maximum values of the grid voltage signals are constantly greater than the fourth predetermined value B and the minimum values of the grid voltage signals are constantly less than the fifth predetermined value -B, it is determined that the grid voltage signal is an alternating current signal, and accordingly the grid voltage mode is the alternating current mode.

In an embodiment, it is determined whether both the time duration in which the maximum values of the grid voltage signals in the predetermined time period are greater than the fourth predetermined value and the time duration in which the minimum values of the grid voltage signals in the predetermined time period are less than the fifth predetermined value are greater than the second predetermined duration by: determining whether a maximum value of a grid voltage signal in a current acquisition period is greater than the fourth predetermined value and whether a minimum value of the grid voltage signal in the current acquisition period is less than the fifth predetermined value; in a case that the maximum value of the grid voltage signal in the current acquisition period is greater than the fourth predetermined value and the minimum value of the grid voltage signal in the current acquisition period is less than the fifth predetermined value, increasing a fourth counter by 1; in a case that the maximum value of the grid voltage signal in the current acquisition period is not greater than the fourth predetermined value or the minimum value of the grid voltage signal in the current acquisition period is not less than the fifth predetermined value, decreasing the fourth counter by 1; determining whether a current time period obtained based on the current acquisition period and an initial time instant is greater than the predetermined time period; in a case that the current time period is not greater than the predetermined time period, acquiring a grid voltage signal with the acquisition period; in a case that the current time period is greater than the predetermined time period, determining whether the fourth counter is greater than a sixth predetermined value; and in a case that the fourth counter is greater than the sixth predetermined value, determining that both the time duration in which the maximum values of the grid voltage signals in the predetermined time period are greater than the fourth predetermined value and the time duration in which the minimum values of the grid voltage signals in the predetermined time period are less than the fifth predetermined value are greater than the second predetermined duration.

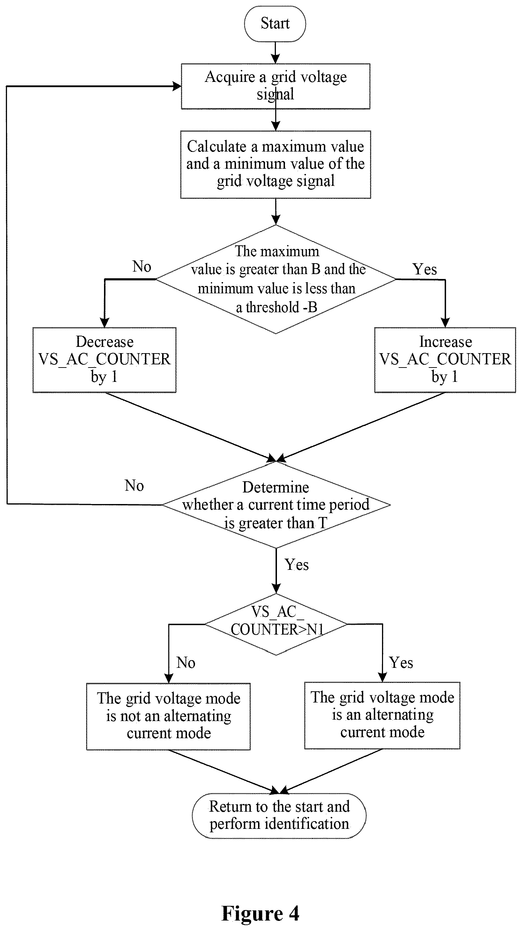

Specifically, as shown in Figure 4, an acquired grid voltage signal is processed to obtain a maximum value and a minimum value of the grid voltage signal. In each of predetermined time periods T, the maximum value of the grid voltage signal is compared with the fourth predetermined value B and the minimum value of the grid voltage signal is compared with the fifth predetermined value -B. In a case that the maximum value of the grid voltage signal is constantly greater than the fourth predetermined value B and the minimum value of the grid voltage signal is constantly less than the fifth predetermined value -B, a fourth counter VS_AC_COUNTER is increased by 1. In a case that the maximum value of the grid voltage signal is not constantly greater than the fourth predetermined value B and the minimum value of the grid voltage signal is not constantly less than the fifth predetermined value -B, the fourth counter VS_AC_COUNTER is decreased by 1. In a case that the fourth counter VS_AC_COUNTER is greater than N1, it is determined that the grid voltage signal is an alternating current signal and the grid-voltage alternating-current flag is set to 1.

It should be understood that in the present disclosure, the determination on whether a grid voltage signal is an alternating current signal and the determination on whether a grid voltage signal is a direct current signal may be performed simultaneously or sequentially, which is not limited in the present disclosure.

In an embodiment, the method for identifying a power supply system further includes: in a case that a grid voltage signal in a current acquisition period meets an initial zero-crossing condition, controlling a fifth counter to start counting; increasing the fifth counter by 1 each time a grid voltage signal is acquired, and controlling the fifth counter to stop counting when the grid voltage signal in the current acquisition period meets a target zero-crossing condition; and obtaining a frequency of the grid voltage signal based on the fifth counter. The initial zero-crossing condition is a condition in which an instant value of a grid voltage signal in a previous acquisition period is less than 0 and an instant value of the grid voltage signal in the current acquisition period is greater than 0, and the target zero-crossing condition is a condition in which the instant value of the grid voltage signal in the previous acquisition period is greater than 0 and the instant value of the grid voltage signal in the current acquisition period is less than 0.

Specifically, after it is determined that the grid voltage mode is the alternating current mode, it is required to further determine the frequency of the alternating-current grid voltage. Common frequencies of the alternating-current grid voltage include 50Hz, 60Hz, 16.7Hz, and the like. In the embodiment, a zero point of an acquired grid voltage, where an instant value of a grid voltage signal in a previous acquisition period is less than zero and an instant value of a grid voltage signal in a current acquisition period is greater than zero, is used as a starting point for a fifth counter, that is, the fifth counter starts counting at the zero point. Each time a grid voltage signal is acquired, the fifth counter is increased by 1 until the acquired grid voltage returns to the zero point. That is, the fifth counter stops counting at a time instant when an instant value of the grid voltage signal in the previous acquisition period is greater than zero and an instant value of the grid voltage signal in the current acquisition period is less than zero. In addition, a time length of a single grid voltage period, that is, a grid voltage frequency, may be calculated based on the fifth counter and the acquisition period. In order to ensure the accuracy of the grid voltage frequency, an average value of multiple periods may be calculated to obtain the grid voltage frequency.

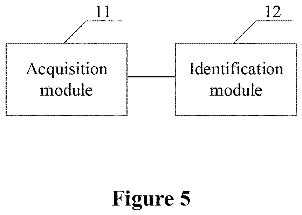

Referring to Figure 5, Figure 5 is a schematic structural diagram of a system for identifying a power supply system according to the present disclosure. The system is applied to a grid-voltage detection device of a multi-system rail vehicle. The system includes an acquisition module 11 and an identification module 12.

The acquisition module 11 is configured to acquire a grid voltage signal with an acquisition period.

The identification module 12 is configured to: identify a grid voltage mode based on instant values of grid voltage signals in multiple acquisition periods in a predetermined time period, where the grid voltage mode includes an alternating current mode or a direct current mode; determine, in a case that that the grid voltage mode is the direct current mode, a current direct-current power supply system based on the instant values of the grid voltage signals in the predetermined time period; and determine, in a case that the grid voltage mode is the alternating current mode, a current alternating-current power supply system based on the instant values and a frequency of the grid voltage signals in the predetermined time period.

It can be seen that in the embodiments, a power supply system is identified by using a grid-voltage detection device in a multi-system rail vehicle without an external device, reducing the cost, avoiding the problem of signal loss, thereby ensuring the operability of the multi-system rail vehicle. Moreover, considering small differences in effective values of grid voltage signals under some power supply systems, the power supply system is identified based on changes of instant values of grid voltage signals in a time period according to the present disclosure, thereby avoiding misidentification and thereby improving the accuracy of identification.

In an embodiment, the grid voltage mode is identified based on the instant values of the grid voltage signals in the multiple acquisition periods in the predetermined time period by: determining whether a time duration, in which the instant values of the grid voltage signals are greater than a first predetermined value, in the predetermined time period is greater than a first predetermined duration; and in a case that the time duration is greater than the first predetermined duration, determining that the grid voltage mode is the direct current mode.

In an embodiment, it is determined whether the time duration, in which the instant value of the grid voltage signals are greater than the first predetermined value, in the predetermined time period is greater than the first predetermined duration by: in a case that an instant value of a grid voltage signal in a current acquisition period is greater than the first predetermined value, increasing a first counter by 1; in a case that an instant value of a grid voltage signal in a current acquisition period is less than a second predetermined value, increasing a second counter by 1; determining whether a current time period obtained based on the current acquisition period and an initial time instant is greater than the predetermined time period; in a case that the current time period is not greater than the predetermined time period, acquiring a grid voltage signal with the acquisition period; in a case that the current time period is greater than the predetermined time period, increasing a third counter by 1 if the first counter is greater than the second counter, and decreasing the third counter by 1 if the first counter is not greater than the second counter; and in a case that the third counter is greater than a third predetermined value, determining that the time duration in which the instant values of the grid voltage signals are greater than the first predetermined value is greater than the first predetermined duration.

In an embodiment, the grid voltage mode is identified based on the instant values of the grid voltage signals in the multiple acquisition periods in the predetermined time period by: determining maximum values and minimum values of the grid voltage signals in the multiple acquisition periods; determining whether both a time duration in which the maximum values of the grid voltage signals in the predetermined time period are greater than a fourth predetermined value and a time duration in which the minimum values of the grid voltage signals in the predetermined time period are less than a fifth predetermined value are greater than a second predetermined duration, where the fourth predetermined value is greater than the fifth predetermined value, and the fourth predetermined value and the fifth predetermined value are opposite numbers to each other; and in a case that both the time duration in which the maximum values of the grid voltage signals in the predetermined time period are greater than the fourth predetermined value and the time duration in which the minimum values of the grid voltage signals in the predetermined time period are less than the fifth predetermined value are greater than the second predetermined duration, determining that the grid voltage mode is the alternating current mode.

In an embodiment, it is determined whether both the time duration in which the maximum values of the grid voltage signals in the predetermined time period are greater than the fourth predetermined value and the time duration in which the minimum values of the grid voltage signals in the predetermined time period are less than the fifth predetermined value are greater than the second predetermined duration by: determining whether a maximum value of a grid voltage signal in a current acquisition period is greater than the fourth predetermined value and whether a minimum value of the grid voltage signal in the current acquisition period is less than the fifth predetermined value; in a case that the maximum value of the grid voltage signal in the current acquisition period is greater than the fourth predetermined value and the minimum value of the grid voltage signal in the current acquisition period is less than the fifth predetermined value, increasing a fourth counter by 1; in a case that the maximum value of the grid voltage signal in the current acquisition period is not greater than the fourth predetermined value or the minimum value of the grid voltage signal in the current acquisition period is not less than the fifth predetermined value, decreasing the fourth counter by 1; determining whether a current time period obtained based on the current acquisition period and an initial time instant is greater than the predetermined time period; in a case that the current time period is not greater than the predetermined time period, acquiring a grid voltage signal with the acquisition period; in a case that the current time period is greater than the predetermined time period, determining whether the fourth counter is greater than a sixth predetermined value; and in a case that the fourth counter is greater than the sixth predetermined value, determining that both the time duration in which the maximum values of the grid voltage signals in the predetermined time period are greater than the fourth predetermined value and the time duration in which the minimum values of the grid voltage signals in the predetermined time period are less than the fifth predetermined value are greater than the second predetermined duration.

In an embodiment, the system for identifying a power supply system further includes a calculation module. The calculation module is configured to: control, in a case that a grid voltage signal in a current acquisition period meets an initial zero-crossing condition, a fifth counter to start counting; increase the fifth counter by 1 each time a grid voltage signal is acquired, and control the fifth counter to stop counting when the grid voltage signal in the current acquisition period meets a target zero-crossing condition; and obtain a frequency of the grid voltage signal based on the fifth counter. The initial zero-crossing condition is a condition in which an instant value of a grid voltage signal in a previous acquisition period is less than 0 and an instant value of the grid voltage signal in the current acquisition period is greater than 0, and the target zero-crossing condition is a condition in which the instant value of the grid voltage signal in the previous acquisition period is greater than 0 and the instant value of the grid voltage signal in the current acquisition period is less than 0.

In another aspect, an electronic device is further provided according to the present disclosure. The electronic device includes a memory and a processor. The memory stores a computer program. The processor is configured to execute the computer program to perform the method for identifying a power supply system according to any one of the above embodiments.

The description of the electronic device according to the present disclosure may refer to the above embodiments, and is not repeated herein.

The electronic device according to the present disclosure has the same beneficial effect as the method for identifying a power supply system described above.

In another aspect, a multi-system rail vehicle is further provided according to the present disclosure. The multi-system rail vehicle includes the electronic device described above.

The description of the multi-system rail vehicle according to the present disclosure may refer to the above embodiments, and is not repeated herein.

The multi-system rail vehicle according to the present disclosure has the same beneficial effect as the method for identifying a power supply system described above.

In another aspect, a computer-readable storage medium is further provided according to the present disclosure. The computer-readable storage medium stores a computer program. The computer program, when executed by a processor, causes the processor to perform the method for identifying a power supply system according to any one of the above embodiments.

The description of the computer-readable storage medium according to the present disclosure may refer to the above embodiments, and is not repeated herein.

The computer-readable storage medium according to the present disclosure has the same beneficial effect as the method for identifying a power supply system described above.

It should be noted that the relationship terms, such as first, second, or the like, in this specification are only used to distinguish one entity or operation from another entity or operation, and do not necessarily require or imply that there is an actual relationship or sequence between these entities or operations. Furthermore, terms "include", "comprise" or any other variants thereof are intended to be non-exclusive. Therefore, a process, method, article or device including a series of elements includes not only the elements but also other elements that are not enumerated or other elements inherent to such process, method, article or device. Unless expressively limited otherwise, the statement "including one..." does not exclude the case that other similar elements may exist in the process, method, article or device.

The above description of the disclosed embodiments enables those skilled in the art to implement or use the present disclosure. Various modifications to the embodiments are obvious to those skilled in the art, and general principles defined in the present disclosure may be implemented in other embodiments without departing from the spirit or scope of the present disclosure. Therefore, the present disclosure is not limited to the embodiments described herein, and conforms to the widest scope that complies with the principle and novelty disclosed in this specification.

## Claims

1. A method for identifying a power supply system, wherein the method is applied to a grid-voltage detection device in a multi-system rail vehicle, and the method comprises:
acquiring a grid voltage signal with an acquisition period;
identifying a grid voltage mode based on instant values of grid voltage signals in a plurality of acquisition periods in a predetermined time period, wherein the grid voltage mode comprises an alternating current mode and a direct current mode;
determining, in a case that that the grid voltage mode is the direct current mode, a current direct-current power supply system based on the instant values of the grid voltage signals in the predetermined time period; and
determining, in a case that the grid voltage mode is the alternating current mode, a current alternating-current power supply system based on the instant values and a frequency of the grid voltage signals in the predetermined time period.

2. The method for identifying a power supply system according to claim 1, wherein the identifying a grid voltage mode based on instant values of grid voltage signals in a plurality of acquisition periods in a predetermined time period comprises:
determining whether a time duration, in which the instant values of the grid voltage signals are greater than a first predetermined value, in the predetermined time period is greater than a first predetermined duration; and
determining, in a case that the time duration is greater than the first predetermined duration, that the grid voltage mode is the direct current mode.

3. The method for identifying a power supply system according to claim 2, wherein the determining whether a time duration, in which the instant values of the grid voltage signals are greater than a first predetermined value, in the predetermined time period is greater than a first predetermined duration comprises:
increasing a first counter by 1 in a case that an instant value of a grid voltage signal in a current acquisition period is greater than the first predetermined value;
increasing a second counter by 1 in a case that an instant value of a grid voltage signal in a current acquisition period is less than a second predetermined value;
determining whether a current time period obtained based on the current acquisition period and an initial time instant is greater than the predetermined time period;
acquiring, in a case that the current time period is not greater than the predetermined time period, a grid voltage signal with the acquisition period;
increasing a third counter by 1 if the first counter is greater than the second counter and decreasing the third counter by 1 if the first counter is not greater than the second counter in a case that the current time period is greater than the predetermined time period; and
determining, in a case that the third counter is greater than a third predetermined value, that the time duration in which the instant values of the grid voltage signals are greater than the first predetermined value is greater than the first predetermined duration.

4. The method for identifying a power supply system according to claim 1, wherein the identifying a grid voltage mode based on instant values of grid voltage signals in a plurality of acquisition periods in a predetermined time period comprises:
determining maximum values and minimum values of the grid voltage signals in the plurality of acquisition periods;
determining whether both a time duration in which the maximum values of the grid voltage signals in the predetermined time period are greater than a fourth predetermined value and a time duration in which the minimum values of the grid voltage signals in the predetermined time period are less than a fifth predetermined value are greater than a second predetermined duration, wherein the fourth predetermined value is greater than the fifth predetermined value, and the fourth predetermined value and the fifth predetermined value are opposite numbers to each other; and
determining that the grid voltage mode is the alternating current mode in a case that both the time duration in which the maximum values of the grid voltage signals in the predetermined time period are greater than the fourth predetermined value and the time duration in which the minimum values of the grid voltage signals in the predetermined time period are less than the fifth predetermined value are greater than the second predetermined duration.

5. The method for identifying a power supply system according to claim 4, wherein the determining whether both a time duration in which the maximum values of the grid voltage signals in the predetermined time period are greater than a fourth predetermined value and a time duration in which the minimum values of the grid voltage signals in the predetermined time period are less than a fifth predetermined value are greater than a second predetermined duration comprises:
determining whether a maximum value of a grid voltage signal in a current acquisition period is greater than the fourth predetermined value and whether a minimum value of the grid voltage signal in the current acquisition period is less than the fifth predetermined value;
increasing a fourth counter by 1 in a case that the maximum value of the grid voltage signal in the current acquisition period is greater than the fourth predetermined value and the minimum value of the grid voltage signal in the current acquisition period is less than the fifth predetermined value;
decreasing the fourth counter by 1 in a case that the maximum value of the grid voltage signal in the current acquisition period is not greater than the fourth predetermined value or the minimum value of the grid voltage signal in the current acquisition period is not less than the fifth predetermined value;
determining whether a current time period obtained based on the current acquisition period and an initial time instant is greater than the predetermined time period;
acquiring a grid voltage signal with the acquisition period in a case that the current time period is not greater than the predetermined time period;
determining whether the fourth counter is greater than a sixth predetermined value in a case that the current time period is greater than the predetermined time period; and
determining, in a case that the fourth counter is greater than the sixth predetermined value, that both the time duration in which the maximum values of the grid voltage signals in the predetermined time period are greater than the fourth predetermined value and the time duration in which the minimum values of the grid voltage signals in the predetermined time period are less than the fifth predetermined value are greater than the second predetermined duration.

6. The method for identifying a power supply system according to claim 1, further comprising:
controlling a fifth counter to start counting in a case that a grid voltage signal in a current acquisition period meets an initial zero-crossing condition;
increasing the fifth counter by 1 each time a grid voltage signal is acquired, and controlling the fifth counter to stop counting when the grid voltage signal in the current acquisition period meets a target zero-crossing condition; and
obtaining a frequency of the grid voltage signal based on the fifth counter;
wherein the initial zero-crossing condition is a condition in which an instant value of a grid voltage signal in a previous acquisition period is less than 0 and an instant value of the grid voltage signal in the current acquisition period is greater than 0, and the target zero-crossing condition is a condition in which the instant value of the grid voltage signal in the previous acquisition period is greater than 0 and the instant value of the grid voltage signal in the current acquisition period is less than 0.

7. A system for identifying a power supply system, wherein the system is applied to a grid-voltage detection device in a multi-system rail vehicle, and the system comprises:
an acquisition module, configured to acquire a grid voltage signal with an acquisition period; and
an identification module, configured to: identify a grid voltage mode based on instant values of grid voltage signals in a plurality of acquisition periods in a predetermined time period, wherein the grid voltage mode comprises an alternating current mode or a direct current mode; determine, in a case that that the grid voltage mode is the direct current mode, a current direct-current power supply system based on the instant values of the grid voltage signals in the predetermined time period; and determine, in a case that the grid voltage mode is the alternating current mode, a current alternating-current power supply system based on the instant values and a frequency of the grid voltage signals in the predetermined time period.

8. The system for identifying a power supply system according to claim 7, wherein the grid voltage mode is identified based on the instant values of the grid voltage signals in the plurality of acquisition periods in the predetermined time period by:
determining whether a time duration, in which the instant values of the grid voltage signals are greater than a first predetermined value, in the predetermined time period is greater than a first predetermined duration; and
determining, in a case that the time duration is greater than the first predetermined duration, that the grid voltage mode is the direct current mode.

9. The system for identifying a power supply system according to claim 8, wherein it is determined whether the time duration, in which the instant value of the grid voltage signals are greater than the first predetermined value, in the predetermined time period is greater than the first predetermined duration by:
increasing a first counter by 1 in a case that an instant value of a grid voltage signal in a current acquisition period is greater than the first predetermined value;
increasing a second counter by 1 in a case that an instant value of a grid voltage signal in a current acquisition period is less than a second predetermined value;
determining whether a current time period obtained based on the current acquisition period and an initial time instant is greater than the predetermined time period;
acquiring a grid voltage signal with the acquisition period in a case that the current time period is not greater than the predetermined time period;
increasing a third counter by 1 if the first counter is greater than the second counter and decreasing the third counter by 1 if the first counter is not greater than the second counter in a case that the current time period is greater than the predetermined time period; and
determining, in a case that the third counter is greater than a third predetermined value, that the time duration in which the instant values of the grid voltage signals are greater than the first predetermined value is greater than the first predetermined duration.

10. The system for identifying a power supply system according to claim 7, wherein the grid voltage mode is identified based on the instant values of the grid voltage signals in the plurality of acquisition periods in the predetermined time period by:
determining maximum values and minimum values of the grid voltage signals in the plurality of acquisition periods;
determining whether both a time duration in which the maximum values of the grid voltage signals in the predetermined time period are greater than a fourth predetermined value and a time duration in which the minimum values of the grid voltage signals in the predetermined time period are less than a fifth predetermined value are greater than a second predetermined duration, wherein the fourth predetermined value is greater than the fifth predetermined value, and the fourth predetermined value and the fifth predetermined value are opposite numbers to each other; and
determining that the grid voltage mode is the alternating current mode in a case that both the time duration in which the maximum values of the grid voltage signals in the predetermined time period are greater than the fourth predetermined value and the time duration in which the minimum values of the grid voltage signals in the predetermined time period are less than the fifth predetermined value are greater than the second predetermined duration.

11. The system for identifying a power supply system according to claim 10, wherein it is determined whether both the time duration in which the maximum values of the grid voltage signals in the predetermined time period are greater than the fourth predetermined value and the time duration in which the minimum values of the grid voltage signals in the predetermined time period are less than the fifth predetermined value are greater than the second predetermined duration by:
determining whether a maximum value of a grid voltage signal in a current acquisition period is greater than the fourth predetermined value and whether a minimum value of the grid voltage signal in the current acquisition period is less than the fifth predetermined value;
increasing a fourth counter by 1 in a case that the maximum value of the grid voltage signal in the current acquisition period is greater than the fourth predetermined value and the minimum value of the grid voltage signal in the current acquisition period is less than the fifth predetermined value;
decreasing the fourth counter by 1 in a case that the maximum value of the grid voltage signal in the current acquisition period is not greater than the fourth predetermined value or the minimum value of the grid voltage signal in the current acquisition period is not less than the fifth predetermined value;
determining whether a current time period obtained based on the current acquisition period and an initial time instant is greater than the predetermined time period;
acquiring a grid voltage signal with the acquisition period in a case that the current time period is not greater than the predetermined time period;
determining whether the fourth counter is greater than a sixth predetermined value in a case that the current time period is greater than the predetermined time period; and
determining, in a case that the fourth counter is greater than the sixth predetermined value, that both the time duration in which the maximum values of the grid voltage signals in the predetermined time period are greater than the fourth predetermined value and the time duration in which the minimum values of the grid voltage signals in the predetermined time period are less than the fifth predetermined value are greater than the second predetermined duration.

12. The system for identifying a power supply system according to claim 7, further comprising:
a calculation module, configured to: control, in a case that a grid voltage signal in a current acquisition period meets an initial zero-crossing condition, a fifth counter to start counting; increase the fifth counter by 1 each time a grid voltage signal is acquired, and control the fifth counter to stop counting when the grid voltage signal in the current acquisition period meets a target zero-crossing condition; and obtain a frequency of the grid voltage signal based on the fifth counter; wherein
the initial zero-crossing condition is a condition in which an instant value of a grid voltage signal in a previous acquisition period is less than 0 and an instant value of the grid voltage signal in the current acquisition period is greater than 0, and the target zero-crossing condition is a condition in which the instant value of the grid voltage signal in the previous acquisition period is greater than 0 and the instant value of the grid voltage signal in the current acquisition period is less than 0.

13. An electronic device, comprising:
a memory, storing a computer program; and
a processor, configured to execute the computer program to perform the method for identifying a power supply system according to any one of claims 1 to 6.

14. A multi-system rail vehicle, comprising the electronic device according to claim 13.

15. A computer-readable storage medium storing a computer program, wherein the computer program, when executed by a processor, causes the processor to perform the method for identifying a power supply system according to any one of claims 1 to 6.
